# EUROPEAN PATENT APPLICATION

(11) **EP 0 569 068 A1**
(43) Date of publication of application: **10.11.1993**
(21) Application number: 93200994.7
(22) Date of filing: 06.04.1993
(51) Int. Cl.: G03F 7/07, G03D 3/06, G03C 5/31, G03C 5/395

(54) **Method for processing a photographic material**

(30) Priority: 07.05.1992 EP 92201297
(71) Applicant: AGFA-GEVAERT naamloze vennootschap, B-2640 Mortsel (BE)
(72) Inventor: Vackier, Leo, B-2640 Mortsel (BE); Claes, Jan, B-2640 Mortsel (BE); Coppens, Paul, B-2640 Mortsel (BE)

(57) **Abstract**

The present invention provides a method for obtaining a desired number of images comprising the steps of information-wise exposing a number of imaging elements containing a silver halide emulsion layer and subsequently processing said imaging elements using one or more processing liquids characterized in that at least one of said processing liquids is replenished after or during processing of an imaging element by replacing an amount of said processing liquid at least corresponding to the product of the amount of imaging element (in m2) processed since the last replenishment or since the start with fresh processing liquid and the inverse of the exhaustion of said processing liquid by fresh processing liquid and wherein said exhaustion of a processing liquid is the amount of imaging element (in m2) that can be processed per liter of corresponding fresh processing liquid without replenishment untill one or more properties of said imaging element deviate for more than 20% from the initial values obtained with said corresponding fresh processing liquid.

## Description

### 1. Field of the invention.

The present invention relates to a method for obtaining a desired number of images using photographic material and to a method for producing a desired number of lithographic aluminium offset printing plates by the silver complex diffusion transfer process and an apparatus for processing photographic material.

### 2. Detailed description of the invention.

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image-receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellant ink-receptive areas on a water-receptive ink-repellant background.

For example EP-A-410500 discloses an imaging element containing an aluminium support provided with in the order given an image receiving layer containing physical development nuclei and a photosensitive layer containing a silver halide emulsion. According to the there disclosed method for obtaining a lithographic printing plate said imaging element is image-wise exposed and subsequently developed using a developing liquid or activating liquid in the presence of a silver halide complexing agent. The imaging element is then guided through a diffusion transfer zone so that the silver halide complexes formed during the development step are allowed to diffuse into the image-receiving layer where they are converted to silver. When the imaging element leaves the diffusion transfer zone a silver image is formed in the image receiving layer. The now useless photosensitive layer and optional other layers above the image receiving layer are then removed by rinsing the imaging element in a washing section. Finally the element now carrying a silver image on its surface is treated with a finishing liquid that contains so called hydrophobizing agents for improving the hydrophobicity of the silver image.

In the above described method for obtaining an aluminium based lithographic printing plate according to the DTR-process at least 3 different liquids are used i.e. a developing or activating liquid, a rinsing liquid and a finishing liquid. Generally these liquids are used untill they are exhausted i.e. untill their activity has been dropped below a certain level and they are then replaced by fresh liquid. This method has the following disadvantages. A large waste of processing liquid is produced because not all of the processing liquid is effectively used. The speed of the imaging element and the quality of the obtained printing plate will change with the amount of material already processed therein. The liquids, especially the developing or activating liquid, are highly susceptible to oxidation while other liquids such as the rinsing liquid or finishing liquids will become polluted or the active component(s) thereof will be consumed. The latter two disadvantages can be partially solved by regenerating the processing liquid with a concentrate thereof. However such regeneration requires additional types of liquids which is inconvenient and confusing. Further such regeneration will not be able to compensate the loss of activity due to polution of the liquid or oxidation of an active compound by oxygen from the air so that after a certain time the complete liquid has to be replaced. Such method is therefore especially inconvenient when an automatic processing apparatus is used for processing the imaging element.

The problem of activity drop of a processing liquid for obtaining an aluminium based lithographic printing plate is also encountered in the processing of other photographic materials.

### 3. Summary of the invention.

Accordingly it is an object of the present invention to provide a method for processing a number of photographic materials comprising a silver halide emulsion layer wherein the aforementioned problem of activity drop of one or more processing liquids used during processing of the photographic materials is avoided.

It is an object of the present invention to provide a method for processing a number of lithographic aluminium offset printing plates by the silver complex diffusion transfer process not suffering from the above mentioned disadvantages.

It is also an object of the present invention to provide an apparatus for processing photographic materials and for making an aluminium based lithographic printing plates according to the DTR process.

Further objects will become clear from the description hereinafter.

According to the present invention there is provided a method for obtaining a desired number of images comprising the steps of information-wise exposing a number of imaging elements containing a silver halide emulsion layer and subsequently processing said imaging elements using one or more processing liquids characterized in that at least one of said processing liquids is replenished after or during processing of an imaging element by replacing an amount of said processing liquid at least corresponding to the product of the amount of imaging element (in m²) processed since the last replenishment or since the start with fresh processing liquid and the inverse of the exhaustion of said processing liquid by fresh processing liquid and wherein said exhaustion of a processing liquid is the amount of imaging element (in m2) that can be processed per liter of corresponding fresh processing liquid without replenishment untill one or more properties of the imaging element deviate for more than 20% from the initial values obtained with the corresponding fresh processing liquid.

According to the present invention there is provided a method for producing a desired number of lithographic aluminium offset printing plates by the silver complex diffusion transfer process comprising the steps of:
- developing a number of image-wise exposed imaging elements comprising on an aluminium support in the order given an image receiving layer containing physical development nuclei and a silver halide emulsion layer using a developing liquid or alkaline activating liquid,
- allowing the formation of a silver image in said image receiving layer,
- removing said silver halide emulsion layer using a rinsing liquid and
- treating the silver image obtained in said image receiving layer using a finishing liquid characterized in that at least one of aforementioned processing liquids is replenished after or during processing of an imaging element by replacing an amount of said processing liquid at least corresponding to the product of the amount of imaging element (in m2) processed since the last replenishment or since the start with fresh processing liquid and the inverse of the exhaustion of said processing liquid by fresh processing liquid.

The present invention includes also an apparatus for processing a photographic material and for making a lithographic aluminium offset plate.

### 4. Detailed description of the invention.

It has been found that the activity of a processing liquid when replenished in accordance with the present invention decreases during an initial period of processing and then reaches a constant level of activity. The constant level of activity can be set by varying the amount of processing liquid that is replaced or by setting the activity of the fresh processing liquid. The initial period during which the activity of the processing liquid decreases depends on the total volume of the processing liquid and the rate at which the active component(s) of the processing liquid are consumed or the rate by which the processing liquid becomes polluted. Thus for larger volumes of processing liquid more material has to be processed and thus more replenishment of said processing liquid has to be performed before the constant level of activity is reached. Further when the rate of pollution of the liquid or the rate of consumption of active component(s) in the liquid increases the initial period will shorten.

By the term "fresh processing liquid" is meant a processing liquid corresponding to the processing liquid to be replenished and that has substantially the same composition as said processing liquid before photographic material was processed therein. Preferably the amount of processing liquid replaced during replenishment with fresh processing liquid will be at least 10% more than the minimum required in accordance with the present invention.

The term "exhaustion of a processing liquid" represents the amount of imaging element (in m2) that can be processed per liter of fresh processing liquid without replenishment untill one or more properties of the imaging element deviate for more than 20% from the initial values obtained with the fresh processing liquid.

Thus the exhaustion of a processing liquid can be easily determined as follows. An amount of fresh processing liquid is prepared and is used to process several imaging elements without replenishing the processing liquid. The other processing liquids used in the processing of the imaging element are kept at a constant level of activity for example by completely replacing them each time an imaging element has been processed. Each time an imaging element has been processed one or more photographic properties thereof are measured. When one of the photographic properties being monitored deviates more than 20% from the initial value of the photographic property obtained for the first imaging element processed the liquid is exhausted and the exhaustion of the processing liquid is then obtained by dividing the amount of imaging element processed (in m²) by the initial volume of the processing liquid.

Photographic properties that can be measured for determining the exhaustion of a processing liquid are e.g. the maximum or minimum density of the silver image, the silver yield obtained in the image receiving layer of an unexposed imaging element, speed of the imaging element etc..

Replenishment according to the present invention of a processing liquid may be carried out during processing of the imaging element but is preferably carried out when no imaging element is being processed. Preferably replenishment of a processing liquid takes place each time an amount of imaging element (in m2) has been processed corresponding to at most 50%, more preferably at most 30% and most preferably at most 20% of the amount of imaging element that can be processed with 1 liter according to the "exhaustion" defined above of said processing liquid. This means that when the "exhaustion" of a particular liquid is 5m² per liter the replenishment takes place most preferably when at most 1m² has been processed.

The method of the present invention is further described in more detail for obtaining an aluminium based lithographic printing plate without however limiting the invention thereto.

The imaging element used in connection with the present invention for obtaining an aluminium based lithographic printing plate comprises on an aluminium support an image receiving layer containing physical development nuclei and a silver halide emulsion layer on top thereof. Preferably the imaging element also comprises an intermediate hydrophilic layer containing a non-proteinic hydrophilic film forming polymer or polymer beads or a mixture thereof. Details about the preparation of said imaging element can be found in for example EP-A-410500 and EP-A-483415.

According to the present invention an imaging element as described in e.g. EP-A-410500 is information-wise exposed and subsequently guided through an alkaline processing liquid. Said alkaline processing liquid preferably has a pH between 10 and 14 and preferably also contains one or more of the silver halide solvents used in the DTR process. Preferably used silver halide solvents are e.g. thiosulphate or thiocyanate. The silver halide solvents may also at least partially be present in one or more layers of the imaging element.

The alkaline processing liquid may further contain one or more developing agents used for developing the silver halide. Alternatively the developing agents can be completely incorporated in the imaging element. In the latter case the alkaline processing liquid is called an activating liquid while in the former case it is called a developing liquid. Suitable developing agents for the exposed silver halide are e.g. hydroquinone-type and 1-phenyl-3-pyrazolidone-type developing agents as well as p-monomethylaminophenol and derivatives thereof. Preferably used is a combination of a hydroquinone-type and 1-phenyl-3-pyrazolidone-type developing agent wherein the latter is preferably incorporated in one of the layers comprised on the support of the photographic material. A preferred class of 1-phenyl-3-pyrazolidone-type developing agents is disclosed in the European patent application number EP-A-449340. Other types of developing agents suitable for use in accordance with the present invention are reductones e.g. ascorbic acid derivatives. Such type of developing agents are disclosed in the unpublished European patent application number 91200311.8.

The pH of the alkaline processing liquid may be obtained using inorganic and/or organic alkali. Suitable alkaline substances are e.g. sodium hydroxide, potassium carbonate or alkanolamines or mixtures thereof. Preferably used alkanolamines are tertiary alkanolamines e.g. those described in EP-A-397925, EP-A-397926, EP-A-397927, EP-A-398435 and US-P-4.632.896. A combination of alkanolamines having both a pkₐ above or below 9 or a combination of alkanolamines whereof at least one has a pkₐ above 9 and another having a pkₐ of 9 or less may also be used as disclosed in the Japanese patent applications laid open to the public numbers 73949/61, 73953/61, 169841/61, 212670/60, 73950/61, 73952/61, 102644/61, 226647/63, 229453/63, US-P-4,362,811, US-P-4,568,634 etc..

The alkaline processing solution for use in accordance with the present invention may comprise other additives such as e.g. thickeners, preservatives, detergents e.g. acetylenic detergents such as surfynol 104, surfynol 465, surfynol 440 etc. all available from Air Reduction Chemical Company New York.

Subsequent to the above described development the silver halide complexes formed in the development step are allowed to diffuse into the image receiving layer where they are converted to silver. Generally after 30s to 2 min. a silver image is formed in the image receiving layer.

The silver image is then exposed by rinsing the imaging element in a washing station with a rinsing liquid suitable for removing the silver halide emulsion layer and other optional hydrophilic layers on top of the image receiving layer. Suitable rinsing liquids for removing said layers are e.g. plain water or an aqueous solution. Preferably said rinsing liquid is an aqueous buffer having a pH between 4 and 8.

Subsequent to the removal of the hydrophilic layers on top of the image receiving layer the now exposed silver image is treated with a finishing liquid for improving the hydrophobic properties of the silver image. Suitable hydrophobizing agents for use in this finishing liquid are e.g. those described in US-P 3,776,728, and US-P 4,563,410.

In addition to the above described steps for processing the imaging element according to the method of the present invention additional processing steps may be implemented. For example it is advantageous to include an additional rinsing step following the step where removal of the hydrophilic layers on top of the image receiving layer takes place.

According to a preferred embodiment of the present invention at least the alkaline processing liquid is replenished as explained above. Most preferably all of the processing liquids used for processing the imaging element are replenished as explained above.

The present invention also provides an apparatus for carrying out the method described above for obtaining an image and more particularly for making an aluminium based lithographic printing plate according to the DTR-process.

The apparatus according to the present invention will be described hereinafter by way of example with reference to the following figures wherein:
Fig. 1 is a diagrammatic representation of one embodiment of a processing station of an apparatus according to the invention,
Fig. 2 is a diagrammatic representation of one embodiment of an apparatus according to the invention for making an aluminium based lithographic printing plate.

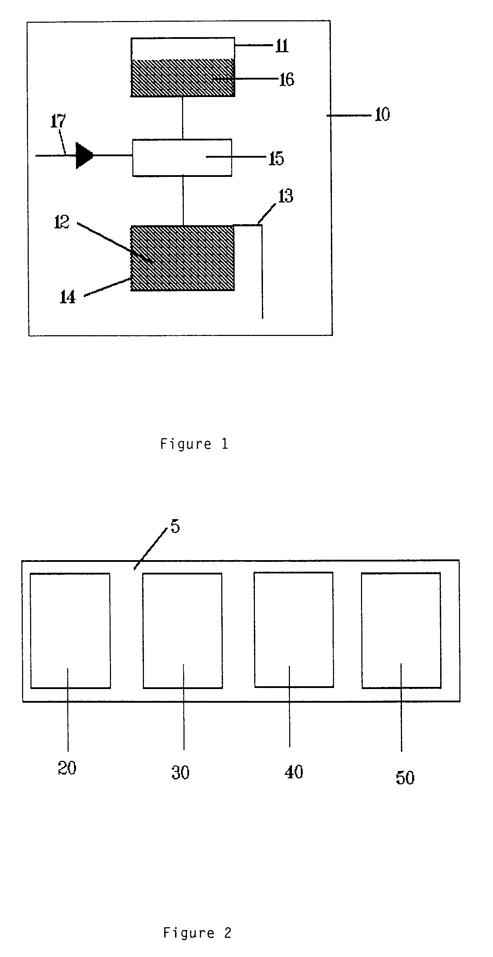

Reference is made to figure 1 showing a processing station (10) of an apparatus according to the invention. The processing station (10) comprises a tank (14) for holding a processing liquid (12), a means (13) for removing a predetermined amount of processing liquid (12), a reservoir (11) for holding fresh processing liquid (16) and means (15) for dosing an amount of fresh processing liquid (16) into tank (14) during replenishment. Upon a signal on line (17) from e.g. someone operating the apparatus, dosing means (15) is controlled to add a certain amount of fresh processing liquid (16) into tank (14). Before or during said addition of fresh processing liquid means (13) will remove an amount of processing liquid (12) equal to the amount of fresh processing liquid (16) being added into tank (14). Suitable means (13) are e.g. an overflow, a volumetric pump etc.. A suitable dosing means (15) is e.g. a volumetric pump. According to the present invention the total amount of fresh processing liquid (16) that will be added into tank (14) for replacing an amount of processing liquid (12) will at least correspond to the product of the amount of imaging elements (in square meters) processed since the last replenishment or since the start with fresh processing liquid and the inverse of the exhaustion of the processing liquid (12). The total amount of fresh processing liquid (16) to be dosed into tank (14) may be dosed thereto in response to one signal on line (17) or several signals may be generated to assure that the desired amount of fresh processing liquid in accordance with the present invention is dosed into tank (14). The signals on line (17) may also be produced by a means for measuring the amount of imaging element processed such as for example a computer collecting signals from sensors measuring the amount of imaging elements processed and generating signals on line (17) according to the collected signals and data and/or instructions contained in said computer.

Figure 2 represents a diagrammatic view of an apparatus (5) for making an aluminium based lithographic printing plate according to the invention comprising a development station (20), a diffusion transfer zone (30), a rinsing station (40) and a finishing station (50). At least one of said development station (20), rinsing station (40) and finishing station (50) is a processing station (10) as described above.

According to the present invention an information-wise exposed imaging element as described above is fed through the development station (20) containing an alkaline processing liquid as described above. Subsequently the imaging element is transported through the diffusion transfer zone where the silver salt complexes formed are allowed to diffuse to the image receiving layer where they are converted to metallic silver. In the diffusion transfer zone the imaging element is merely transported so that by controlling the length of the zone and the transportation speed of the imaging element the time allowed for diffusion of the silver salt complexes can be controlled. The imaging element then enters the rinsing station (40) containing a rinsing liquid e.g. water and sprays or jets for spraying the rinsing liquid onto the imaging element thereby removing the silver halide emulsion layer and other optional layers so that the silver image formed in the image receiving layer is exposed. The silver image is then treated in the finishing station (50) with a finishing liquid as described above by guiding the imaging element through the finishing liquid. The imaging element may then leave the apparatus and an aluminium based lithographic printing plate is obtained.

The present invention is further illustrated by the following examples without however limiting it thereto.

### EXAMPLE 1 (comparitive)

Imaging elements (having an A3-format) were prepared as described in Example 1 of US-P-5.068.165 (invention sample). The following processing solutions were prepared:

| - developing liquid: | |
|---|---|
| carboxymethylcellulose | 4 g |
| sodium hydroxide | 22.5 g |
| anhydrous sodium sulphite | 120 g |
| hydroquinone | 20 g |
| 1-phenyl-3-pyrazolidinone | 6 g |
| potassium bromide | 0.75 g |
| anhydrous sodium thiosulphate | 8 g |
| ethylene diamine tetraacetic acid tetrasodium salt | 3.2 g |
| demineralized water to make | 1000 ml |

| - rinsing liquid (pH=5.7): | |
|---|---|
| NaH₂PO₄.2H₂O | 20g/l |
| Na₂HPO₄.12H₂O | 4.5g/l |
| water to make | 1 liter |

| - finishing liquid | |
|---|---|
| 10% aqueous n-hexadecyl trimethyl ammonium chloride | 25 ml |
| 20% aqueous solution of polystyrene sulphonic acid | 100 ml |
| potassium nitrate | 12.5 g |
| citric acid | 20.0 g |
| 1-phenyl -5-mercaptotetrazole | 2.0 g |
| sodium hydroxide | 5.5 g |
| water to make | 1000 ml |
| pH (20°C) = 4 | |

A number of unexposed imaging elements were processed as follows using the above described processing liquids. First the imaging elements were immersed for 8s in 1 liter of the developing liquid at 25°C. The initiated diffusion transfer was allowed to continue for 20 s to form a silver image in the image receiving layer. Subsequently the imaging elements were rinsed during 10s with a jet using the rinsing liquid and they were then immersed in the finishing liquid for 10s.

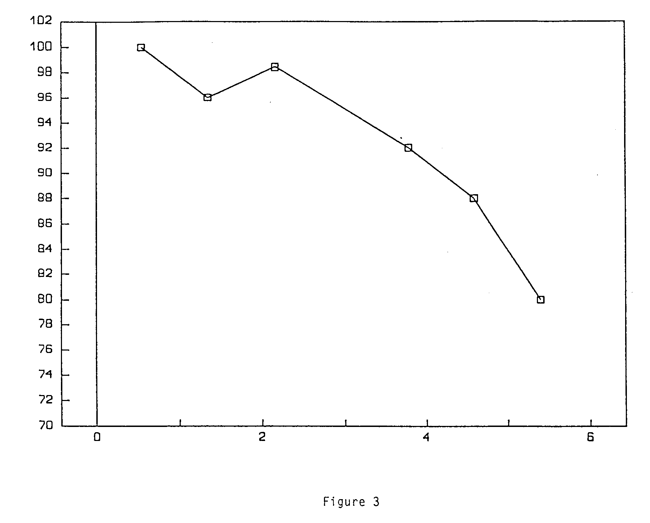

Each time an imaging element was processed the rinsing liquid and finishing liquid were completely replaced with respectively fresh rinsing liquid and fresh finishing liquid. The developing liquid was not replenished. The amount of silver (silver yield) obtained in the image receiving layer for each of the imaging elements was measured using an analytical X-ray Fluorescence Spectrophotometer PHILIPS 1400 (commercially available from Philips). In figure 3 the amount of silver obtained relative to the amount obtained for the first imaging element is shown as a function of the amount of imaging element (in m²) processed. Each measurement shown in figure 3 is an average of silver yields obtained at 6 different places on the imaging elements.

From figure 3 it can be seen that the activity of the developing liquid decreases with the amount of imaging element processed. It can further be seen that after the processing of about 5.5m² of imaging element the developing liquid is exhausted since the silver yield deviates for at least 20% from the initial value. The exhaustion of the developing liquid is thus 5.5m²/l.

### EXAMPLE 2

Imaging elements were prepared as in example 1. The unexposed imaging elements were processed as in example 1 with the difference however that the developing liquid was replenished each time 1 m² of imaging element has been processed. The amount of developing liquid that was replenished was 200ml being 10% more than the product of 1m² of imaging element processed with the inverse of the exhaustion which is 5.5m² per liter.

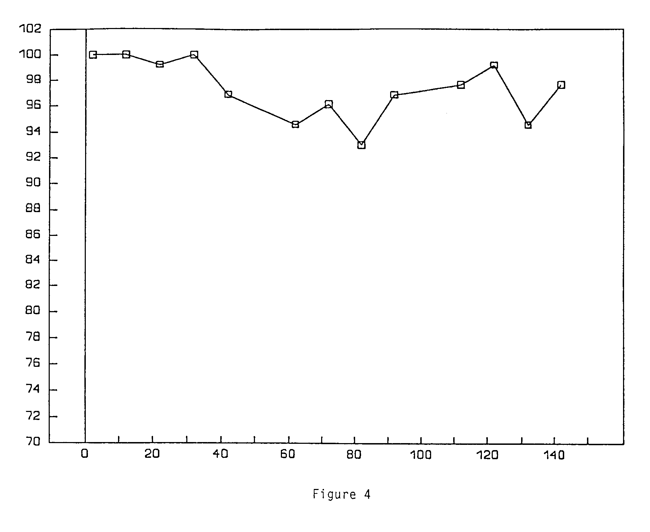

In figure 4 silver yield obtained relative to the yield obtained for the first imaging element is shown as a function of the amount of imaging element (in m²). From figure 4 it can be seen that the silver yield remains constant over the amount of imaging element processed.

## Claims

1. A method for obtaining a desired number of images comprising the steps of information-wise exposing a number of imaging elements containing a silver halide emulsion layer and subsequently processing said imaging elements using one or more processing liquids characterized in that at least one of said processing liquids is replenished after or during processing of an imaging element by replacing an amount of said processing liquid at least corresponding to the product of the amount of imaging element (in m2) processed since the last replenishment or since the start with fresh processing liquid and the inverse of the exhaustion of said processing liquid by fresh processing liquid and wherein said exhaustion of a processing liquid is the amount of imaging element (in m2) that can be processed per liter of corresponding fresh processing liquid without replenishment untill one or more properties of said imaging element deviate for more than 20% from the initial values obtained with said corresponding fresh processing liquid.

2. A method for producing a desired number of lithographic aluminium offset printing plates by the silver complex diffusion transfer process comprising the steps of:
- developing a number of image-wise exposed imaging elements comprising on an aluminium support in the order given an image receiving layer containing physical development nuclei and a silver halide emulsion layer using a developing liquid or alkaline activating liquid,
- allowing the formation of a silver image in said image receiving layer,
- removing said silver halide emulsion layer using a rinsing liquid and
- treating the silver image obtained in said image receiving layer using a finishing liquid characterized in that at least one of aforementioned processing liquids is replenished after or during processing of an imaging element by replacing an amount of said processing liquid at least corresponding to the product of the amount of imaging element (in m2) processed since the last replenishment or since the start with fresh processing liquid and the inverse of the exhaustion of said processing liquid by fresh processing liquid and wherein said exhaustion of a processing liquid is the amount of imaging element (in m2) that can be processed per liter of corresponding fresh processing liquid without replenishment untill one or more properties of said imaging element deviate for more than 20% from the initial values obtained with said corresponding fresh processing liquid.

3. A method according to claim 1 or 2 wherein said processing liquid that is replenished with said amount is a developing liquid or alkaline activating liquid.

4. A method according to any of the above claims wherein said replenishment of a processing liquid is carried out each time at most 50% of the amount of imaging element (in m2) that can be processed with 1 liter of said processing liquid according to its exhaustion has been processed.

5. An apparatus for processing a photographic material comprising at least one processing station (10) with a tank (14) for holding a processing liquid (12), a reservoir (11) for holding an amount of fresh processing liquid (16), dosing means (15) for dosing a predetermined amount of fresh processing liquid (16) into tank (14) during replenishment and means (13) for removing a corresponding amount of processing liquid (12) from tank (14) characterized in that said predetermined amount of fresh processing liquid (16) corresponds at least to the product of the amount of imaging element (in m2) processed since the last replenishment or since the start with fresh processing liquid and the inverse of the exhaustion of said processing liquid and wherein said exhaustion of a processing liquid is the amount of imaging element (in m2) that can be processed per liter of corresponding fresh processing liquid without replenishment untill one or more properties of said imaging element deviate for more than 20% from the initial values obtained with said corresponding fresh processing liquid.

6. An apparatus for processing a photographic material to a lithographic aluminium offset plate containing a developing station (20), a diffusion transfer zone (30), a rinsing station (40) and finishing station (50) characterized in that the developing station (20), the rinsing station (40) or the finishing station (50) is a processing station according to claim 5.

7. An apparatus according to claim 5 or 6 wherein replenishment of a processing liquid takes place each time at most 50% of the amount of imaging element (in m2) that can be processed with 1 liter of said processing liquid according to its exhaustion has been processed.
